(19) Europäisches Patentamt
European Patent Office
Office européen des brevets

(11) **EP 1 564 560 B1**

(12) **EUROPEAN PATENT SPECIFICATION**

(45) Date of publication and mention
of the grant of the patent:
**08.10.2008 Bulletin 2008/41**

(51) Int Cl.:
*G01R 27/28* (2006.01)     *H04B 3/46* (2006.01)

(21) Application number: **04013970.1**

(22) Date of filing: **15.06.2004**

(54) **Method and apparatus for determining the phase distortion of a device under test using a sprectrum analyser**

Verfahren und Vorrichtung zur Ermittlung der Phasenverzerrung einer zu testenden Anordnung mit einem Spektrumanalysator

Méthode et appareil pour déterminer la distorsion de phase d'un dispositif à tester utilisant un analyseur de spectre

(84) Designated Contracting States:
**DE GB**

(30) Priority: **13.02.2004 EP 04003280**

(43) Date of publication of application:
**17.08.2005 Bulletin 2005/33**

(73) Proprietor: **Rohde & Schwarz GmbH & Co. KG
81671 München (DE)**

(72) Inventor: **Kikkert, Cornelis Jan
Annandale
Queensland 4814 (AU)**

(74) Representative: **Körfer, Thomas et al
Mitscherlich & Partner
Patent- und Rechtsanwälte
Postfach 33 06 09
80066 München (DE)**

(56) References cited:
EP-A- 0 747 714          US-A- 5 337 014
US-A1- 2004 095 995      US-B1- 6 480 006

**Description**

The invention relates to a method and apparatus for determining the phase distortion of a device under test using a spectrum analyser.

A network analyser determines the transfer behaviour of a device under test (DUT) in a specific wave band. The transfer behaviour of a device under test in a specific wave band is characterised by the amplitude and phase change of a test signal passing the device under test. The input signal to the network under test is denoted the "Reference signal". The output from the network under test, at the input to the spectrum or network analyser is called the "measured signal"

A typical network analyser is for example shown in DE 198 57 834 A1.

In a typical network analyser a waveform generator produces a sinewave signal at a particular frequency. This sinewave signal is then passed through the device under test and a vector analyser measures the amplitude and the phase of the sinewave signal from the waveform generator after it has passed through the device, thus imparting an amplitude and phase change to this signal. The phase change due to the device is determined by comparing the sinewave reference signal produced by means of the waveform generator, with the same sinewave signal passed through the device under test. After the measurements for one frequency have been completed, the next frequency is generated and the next amplitude and phase change due to the device under test is determined. Once all the required frequencies have been generated, the complete frequency response of the device under test is known.

It is not always necessary to generate one sinewave signal at a time and to do the measurements sequentially. It is also possible to generate a spread spectrum signal containing many individual sinewaves, like an OFDM signal, and minimising the peak to average power by carefully controlling the phase angles of the individual carriers. To measure the device under test using such a spread spectrum signal requires a Fast Fourier Transform (FFT) to be applied to the time signal, which is the output from the device under test and the input to the vector network analyser. Such a spread spectrum allows all the amplitude and phase components to be measured at the same time, thus avoiding the slow sequential operation of the more traditional network analyser. By applying an FFT to the reference signal and comparing the amplitude and phase of each frequency component of the reference and measured signals, the amplitude and phase of the transfer behaviour of the device under test can be determined.

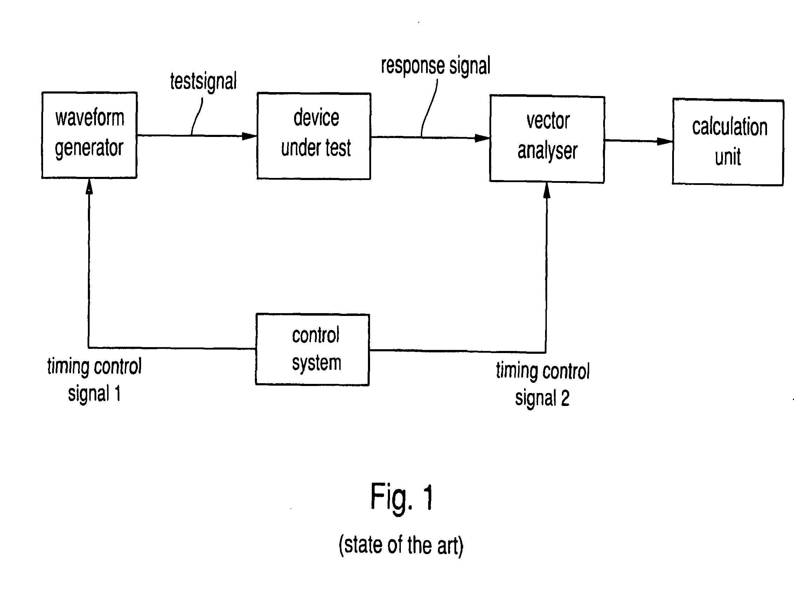

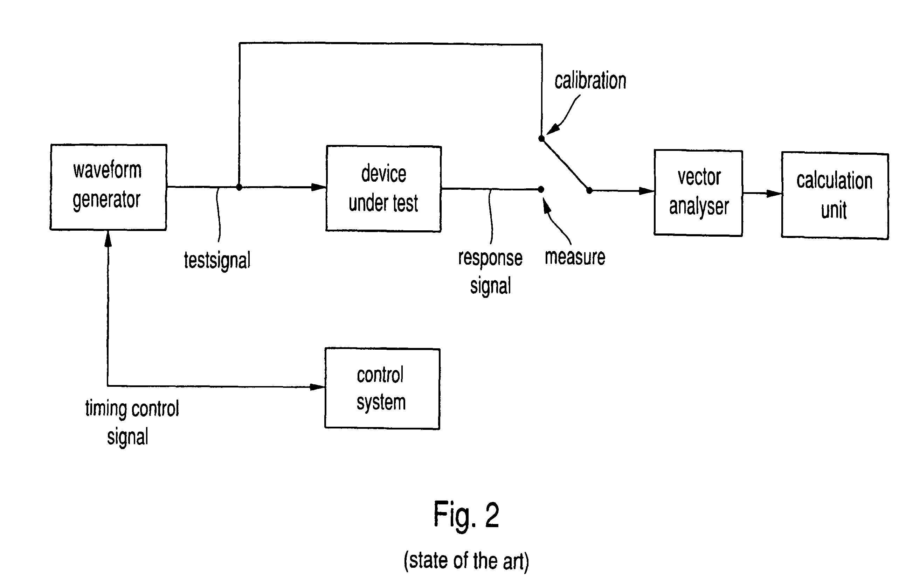

To obtain the correct phase information of the transfer behaviour, both the reference signal from the waveform generator and the measured signal from the device under test must be digitised at the same time, using a dual input sampling system according to Fig. 1. It is, however, also possible to determine the reference phases to be used as part of the FFT-vector analyser by using one timing control signal produced by means of the control system to trigger the waveform generator. In a calibration phase of the vector analyser the reference phases are calibrated by replacing the device under test with a direct through connection leading the reference test signal to the vector analyser to start the sampling process in the vector analyser. The phase of this calibration signal is then used as reference phase to calculate the phase shift caused by the device under test in a measure-phase of the vector analyser. Thus a single input sampling system according to Fig. 2 is realised.

Vector analysers sample and store a selected time interval of a signal with the selected number of samples determined by the sampling frequency and the length of time required. The RF measurement bandwidth must be larger than the signal bandwidth. To minimise the effect of noise, timing errors and random measurement errors, the measurements can be repeated, digitally filtered and averaged. Such processing is, however, slow, requires much computation and significantly increases the number of samples that must be obtained. For example to obtain a digitally filtered bandwidth comparable to a typical spectrum analyser display with a 100Hz IF bandwidth and a 100MHz RF bandwidth, more than 2Million samples are required in the measured waveform, requiring a 2M FFT. Furthermore, vector analysers are very expensive and comparably less commonplace test equipment for determining the transfer behaviour of a device under test.

Spectrum analysers, whose different structural concepts are displayed in the book Christoph Rauscher, "Grundlagen der Spektrumanalyse", Rohde & Schwarz GmbH & Co. KG, München, 2000, pages 19 to 33, are much less expensive and more commonplace test equipment than vector analysers. In contrast to vector analysers spectrum analysers normally only allow the magnitude of individual spectral components to be measured, thus preventing phase information to be determined for the device under test.

EP-A-0 747 714 discloses a noise measurement test system for making phase noise and amplitude noise measurements of microwave signals derived from a continuous wave RF source. The system comprises an RF input for receiving an applied RF noise signal and an RF coupler coupled to the RF input for splitting the applied RF noise signal into first and second paths. A mixer that comprises a synchronous phase detector is coupled to receive signals from the first and second paths, respectively, and which outputs demodulated phase noise. The first path comprises a variable attenuator and a variable phase shifter coupled between the coupler and the first input of the mixer for providing a reference signal input to the synchronous detector. The second path comprises a delay line and an adjustable RF carrier nulling circuit coupled between coupler and the mixer. A video amplifier is coupled to an output of the mixer for providing a baseband video output signal from the system that is processed to produce noise data.

The object of the invention is to develop an efficient method and apparatus for determining the phase distortion caused by a device under test.

The object of the invention is solved by the method for determining the phase distortion caused by the device under test using a spectrum analyser with the features of claim 1 and an apparatus for determining the phase distortion caused by the device under test using a spectrum analyser with the features of claim 7.

According to the invention the phase difference between the reference signal and the measured signal of a device under test, which represents the phase distortion caused by the device under test, is determined by referencing the measured signal with a pair of "calibration quadrature" signals, which are synchronised to the reference signal. The calibration quadrature signals can be a single sinewave or they can contain multiple carriers similar to an OFDM like signal.

Thus each frequency component of the measured signal is mapped in an orthogonal coordinate system created by each frequency component of the pair of calibration quadrature signals. If the in-phase signal of the pair of quadrature signals is used as the 0 degree phase reference for the measurement, the phase angle between the in-phase signal and the response signal mapped in the orthogonal coordinate system of the pair of quadrature signals represents the phase distortion caused by a device under test.

The phase angle between the in-phase signal and the response signal in the orthogonal coordinate system created by the pair of quadratured signals can be determined by applying the arctangent function to the in-phase coordinate and the quadrature coordinate of the response signal in the orthogonal coordinate system of the quadrature signals. Therefore the determination of a phase is transformed to the determination of lengths, which can be realised comparatively simply by measuring signal amplitudes. The in-phase and quadrature coordinate of the response signal in the orthogonal coordinate system of the quadrature signal representing abstract non-measurable magnitudes can be calculated, as shown below, by applying trigonometric functions to measurable magnitudes, like the amplitude of the response signal, the amplitude of a signal created by addition of the in-phase signal to the response signal, and the amplitude of a signal created by addition of the quadrature signal to the response signal.

By determining the amplitudes of these signals - response signal, in-phase signal with a known amplitude added to the response signal and quadrature-phase signal with a known amplitude added to the response signal - in three consecutive measurements and applying mathematical calculations to these measured magnitudes the spectrum analyser enabling only the measuring of signal amplitudes can be used to determine the phase distortion caused by a device under test.

In order to determine the phase distortion at selected frequencies, which result due to the nonlinearity of the device under test, spectral lines of the response signal at the selected frequencies, have to be generated for the first measurement by a baseband reference signal comprising of the required spectral lines. Furthermore, an in-phase and a quadrature-phase signal each exactly comprising the spectral lines of the response signal at the selected frequencies have to be added to the response signal for the second and third measurement.

In comparison with a vector analyser, a spectrum analyser guarantees a better measurement accuracy. A spectrum analyser allows individual spectral lines of a signal to be measured and by selecting the appropriate RF and Video filtering bandwidth, the effect of noise is minimised to ensure that accurate measurements can still be made under noisy and high dynamic range conditions. The IF filter bandwidth that is typically used is far smaller than the total signal bandwidth, resulting in a better signal to noise ratio, than a vector analyser without digital filtering. The only spectral measurement points required are the spectral lines corresponding to the selected frequencies where one would desire to know the signal amplitudes. Furthermore, spectrum analysers have no fundamental 180° phase ambiguity for the measurement of spectral lines which are not an integer of the dominant spectral line frequency difference $F_c \pm F_m$ ($F_c$: frequency of the carrier signal; $F_m$: frequency of the modulation signal) occurring at vector analysers.

The inventive apparatus comprises a first and second waveform generator, a control system, a spectrum analyser and a calculation unit.

The first waveform generator generates an OFDM-like reference signal and the second waveform generator generates a pair of quadrature signals at each of the OFDM-like spectral components where measurements are to be made. The in-phase signal of this pair of quadrature signals is in-phase-referenced to the reference signal, whereas the quadrature-phase signal is in quadrature-phase with the in-phase signal.

The synchronising of the phase of the test, the in-phase and the quadrature-phase signal in the first and second waveform generator is controlled by means of a control system.

The scalar-typed spectrum analyser measures the amplitude of spectral lines of the distorted response signal, of a signal generated by addition of the distortion response signal and the in-phase signal, and of a signal generated by the addition of the distortion signal and the quadrature-phase signal at all the frequencies where the amplitude and phase of the network under test is to be determined in three consecutive measurements.

A calculation unit determines the phase distortion of the device under test for each selected frequency in dependency on the amplitude of the measured distorted response signal, of the measured signal generated by addition of the distorted response signal and the in-phase signal and of the measured signal generated by addition of the distorted response signal and the quadrature-phase signal.

The embodiment of the invention is displayed in the drawing and is consecutively described in detail. In the drawing:

Fig. 1 shows a diagram of a first embodiment of an apparatus for determining the phase distortion $\varphi$ caused by a device under test according the state of the art,

Fig. 2 shows a diagram of a second embodiment of an apparatus for determining the phase distortion $\varphi$ caused by a device under test according the state of the art,

Fig. 3 shows a diagram of an inventive apparatus for determining the phase distortion $\varphi$ caused by a device under test,

Fig. 4 shows a flow chart of an inventive method for determining the phase distortion $\varphi$ caused by a device under test and

Fig. 5 shows a vector diagram for determining the phase distortion $\varphi$ caused by a device under test exemplarily for one selected frequency.

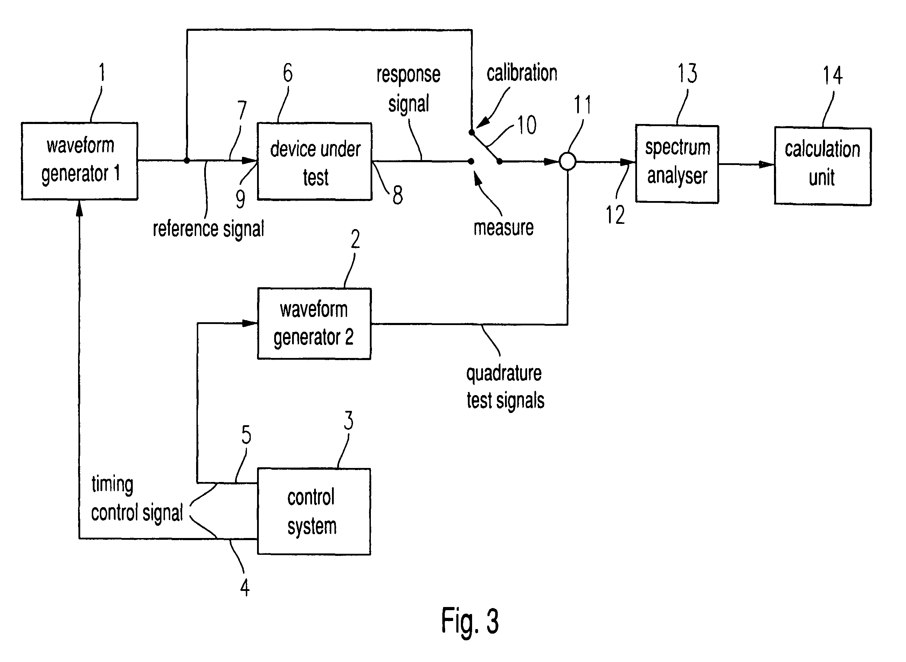

The inventive apparatus and the inventive method for determining the phase distortion $\varphi$ caused by a device under test is consecutively displayed in Fig. 3 to 5.

The inventive apparatus for determining the phase distortion $\varphi$ caused by a device under test in Fig. 3 consists of a first waveform generator 1 producing a reference signal $Y_T(t)$. This reference signal $Y_T(t)$ is a baseband signal comprising at least one spectral line. Typically it is a sinewave modulating signal or a two tone signal comprising two spectral lines or a signal with many frequency components like an OFDM signal. The frequency and the amplitude of the spectral lines of the reference signal $Y_T(t)$ can be adjusted in the first waveform generator 1.

Furthermore, the inventive apparatus consists of a second waveform generator 2 producing a pair of quadrature signals - an in-phase signal $Y_{IP}(t)$ and a quadrature-phase signal $Y_{QP}(t)$ -, which are generated consecutively. The in-phase signal $Y_{IP}(t)$ is in-phase-referenced to the reference signal $Y_T(t)$ in waveform generator 1. Ideally the in-phase signal $Y_{IP}(t)$ has the same phase as the reference signal $Y_T(t)$. The phase of the quadrature-phase signal $Y_{Qp}(t)$ is in quadrature to the phase of the in-phase signal $Y_{IP}(t)$.

For synchronising the phase of the in-phase and the quadrature-phase signal $Y_{IP}(t)$ and $Y_{QP}(t)$ in the second waveform generator 2 to the phase of the reference signal $Y_T(t)$ in the first waveform generator 1 a control system 3 generates two timing control signals having the same phase and is transferred over signal line 4 resp. 5 to the first resp. second waveform generator 1 resp. 2.

The device under test 6 is provided with_the reference signal $Y_T(t)$ over signal line 7. The spectral lines of the response signal $Y_R(t)$ at the output 8 of the device under test 6 are distorted concerning their amplitude and their phase in comparison to the spectral lines of the reference signal $Y_T(t)$ at the input 9 of the device under test 6 (linear distortion). Furthermore, the nonlinear transfer behaviour of the device under test 6 being an amplifier or a mixer for example results in additional spectral lines - higher order harmonics and intermodulation components - in the distorted response signal at the output 8 of the device under test 6 in comparison with the reference signal $Y_T(t)$ at the input 9 of the device under test 6.

The reference signal $Y_T(t)$ is transferred in the calibration mode of the inventive apparatus over the first switch position of a switch 10 and a summation unit 11 having no functionality in the calibration mode to the input 12 of the spectrum analyser 13 for calibrating the spectrum analyser 13 concerning definite phase relations. The distorted response signal $Y_R(t)$ is transferred in the measuring mode of the inventive apparatus over a second switch position of the switch 10 to a summation unit 11. In a first measurement the distorted response signal $Y_R(t)$ from the device under test 6 is transferred over the summation unit 11 to the input 12 of the spectrum analyser 13 without any summation with another signal. In the summation unit 11 the distorted response signal $Y_R(t)$ from the device under test 6 is consecutively added to the in-phase signal $Y_{IP}(t)$ generated in the second waveform generator 2 and transferred to the input 12 of the spectrum analyser 13 for a second measurement. In the summation unit 11 the distorted response signal $Y_R(t)$ from the device under test 6 is added to the quadrature-phase signal $Y_{QP}(t)$ generated in the second waveform generator 2 and transferred to the input 12 of the spectrum analyser 13 for a third measurement.

The spectrum analyser 13 measures the amplitudes of the spectral lines of the distorted response signal $Y_R(t)$ and transfers the amplitudes $M_S$ of those spectral lines, whose frequencies $f_i$ are selected by the user of the inventive apparatus for the determination of the phase distortion $\varphi$, to a calculation unit 14. In the consecutive second and third measurement the spectral analyser measures the amplitudes $M_i$, $M_q$ of the spectral lines of the signal $Y_i(t)$ generated by addition of the distorted response signal $Y_R(t)$ and the in-phase signal $Y_{IP}(t)$ resp. the signal $Y_q(t)$ generated by addition of the distorted response signal $Y_R(t)$ and the quadrature-phase signal $Y_{QP}(t)$ and transfers the amplitudes $M_i$

and $M_q$ of the spectral lines of the signals $Y_i(t)$, $Y_q(t)$ to the calculation unit 14, whose frequencies $f_i$ are selected from the user for the determination of the phase distortion $\varphi$.

The calculation unit 14 determines the phase distortion $\varphi$ of the device under test 6 for each frequency $f_i$ selected by the user on the basis of the amplitudes $M_s$, $M_i$ and $M_q$ of the signals $Y_R(t)$, $Y_i(t)$ and $Y_q(t)$ measured for each selected frequency $f_i$ by means of the spectrum analyser 13 in the first, second and third measurement.

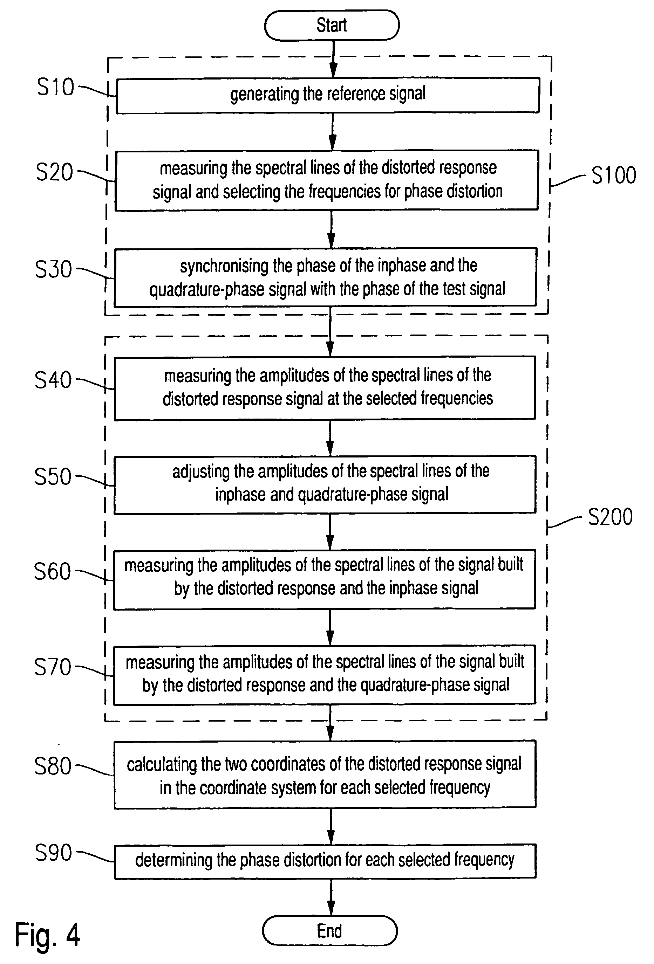

In Fig. 4 a flow of the inventive method for determining the phase distortion $\varphi$ caused by a device under test 6 is displayed.

In the first step S10 of the method a reference signal $Y_T(t)$ being a baseband signal with at least one spectral line is generated in a first waveform generator 1.

The spectral lines of the distorted response signal $Y_R(t)$ caused by a device under test 6 provided with the reference signal $Y_T(t)$ is measured in step S20 by means of a spectrum analyser 13. The user of the inventive apparatus and inventive method selects apropriate frequencies $f_i$ for the determination of the phase distortion $\varphi$ on the base of all the spectral lines of the measured distorted response signal $Y_R(t)$ and their frequencies $f_i$. The selection of the frequencies $f_i$ depends on the desired waveband inclusive its desired frequency grid at the measuring of the phase distortion $\varphi$. Additionally those frequencies $f_i$ are preferably selected, at which only one spectral line of the phase distortion $\varphi$ caused by the device under test is positioned, as shown below.

The in-phase and the quadrature-phase signal $Y_{IP}(t)$ and $Y_{QP}(t)$ exactly comprises the spectral lines of the distorted response signal $Y_R(t)$ at the selected frequencies $f_i$. For each selected frequency $f_i$ in step S20 the phase of the corresponding spectral line of the in-phase signal $Y_{IP}(t)$ and of the quadrature-phase signal $Y_{QP}(t)$ is synchronised with the phase of the reference signal $Y_T(t)$. The phase of the in-phase signal $Y_{IP}(t)$ is reference-phased to the phase of the reference signal $Y_T(t)$. The phase of the quadrature-phase signal $Y_{QP}(t)$ is in quadrature to the in-phase signal $Y_{IP}(t)$. Ideally the in-phase signal $Y_{IP}(t)$ has the same phase as the reference signal $Y_T(t)$ and thus the phase of the quadrature-phase signal $Y_{QP}(t)$ is in quadrature to the phase of the reference signal $Y_T(t)$.

In this manner the in-phase and the quadrature-phase signal $Y_{IP}(t)$ and $Y_{QP}(t)$ compose an orthogonal coordinate system S reference-phased with the reference signal $Y_T(t)$. Therefore by performing the steps S10 to S30 of the inventive method the phase $\varphi$ of the distorted response signal $Y_R(t)$ can be referenced to the orthogonal coordinate system S generated by the in-phase and the quadrature-phase signal $Y_{IP}(t)$ and $Y_{QP}(t)$ according step S100 in claim 1. In the case of equal phase between the reference signal $Y_T(t)$ and the in-phase signal $Y_{IP}(t)$ the phase angle $\varphi$ between the distorted response signal $Y_R(t)$ and the in-phase signal $Y_{IP}(t)$ in the orthogonal coordinate system S represents the phase distortion $\varphi$ of the device under test 6.

In the following step S50 the amplitudes $M_s$ of the spectral lines of the distorted response signal $Y_R(t)$ are measured by means of the spectrum analyser 13 for each selected frequency $f_i$ in a first measurement.

After synchronising the phase of each spectral line of the in-phase and the quadrature-phase signal $Y_{IP}(t)$ and $Y_{QP}(t)$ with the phase of the reference signal $Y_T(t)$ in step S30 the amplitudes $S_s$ and $S_c$ of those spectral lines are adjusted in step S50 to the amplitudes $M_s$ of the corresponding spectral lines of the distorted response signal $Y_R(t)$. Thus the in-phase and the quadrature-phase signal $Y_{IP}(t)$ and $Y_{QP}(t)$ consist of the same spectral lines with the same amplitude and the same frequency as the measured distorted response signal $Y_R(t)$ at the selected frequencies $f_i$.

In a second measurement in step S60 the amplitudes $M_i$ of the spectral lines of a signal $Y_i(t)$ generated by addition of the distorted response signal $Y_R(t)$ and the in-phase signal $Y_{IP}(t)$, whose phases are adjusted in step S30 and whose amplitudes $S_c$ are adjusted in step S50, are measured by means of a spectrum analyser 13 for each selected frequency $f_i$.

Consequently in a third measurement in step S70 the amplitudes $M_q$ of the spectral lines of a signal $Y_q(t)$ generated by addition of the distorted response signal $Y_R(t)$ and the quadrature-phase signal $Y_{QP}(t)$, whose phases are adjusted in step S30 and whose amplitudes $S_s$ are adjusted in step S50, are measured by means of a spectrum analyser 13 for each selected frequency $f_i$.

The steps S40 to S70 accumulate the higher-ranking step S200 according claim 1 in which the amplitudes $M_s$, $M_i$ and $M_q$ of the above mentioned signals $Y_R(t)$, $Y_i(t)$ and $Y_q(t)$ are measured by means of a spectrum analyser 13.

In the following step S80 the x coordinate $S_x$ and the y coordinate $S_Y$ of the distorted response signal $Y_R(t)$ in the orthogonal coordinate system S created by the in-phase signal $Y_{IP}(t)$ and the quadrature-phase signal $Y_{QP}(t)$ representing the phase distortion $\varphi$ of the device under test 6 are calculated by means of a calculation unit 14 for each selected frequency $f_i$. The x coordinate $S_x$ of the distorted response signal $Y_R(t)$ in the orthogonal coordinate system S can be calculated according to equation (1), whereas the y coordinate $S_Y$ of the distorted response signal $Y_R(t)$ in the orthogonal coordinate system S can be calculated according to equation (2). The derivation of the relation for calculating the x coordinate $S_x$ and the y coordinate $S_Y$ of the distorted response signal $Y_R(t)$ in the orthogonal coordinate system S according to equation (1) and (2) is shown below.

$$S_x = \frac{M_i{}^2 - M_s{}^2 - S_c{}^2}{2 * S_c} \qquad (1)$$

$$S_Y = \frac{M_q{}^2 - M_s{}^2 - S_s{}^2}{2 * S_s} \qquad (2)$$

In the concluding step S90 of the inventive method the phase angle φ between the distorted response signal $Y_R(t)$ and the x coordinate axis of the orthogonal coordinate system S building in-phase signal $Y_{IP}(t)$ representing the phase distortion φ of the device under test 6 is determined for each selected frequency $f_i$ according equation (3):

$$\varphi = \arctan\left(\frac{S_Y}{S_x}\right) \qquad (3)$$

In the method for determining the phase distortion φ of a device under test 6 described above the phase distortion φ is determined for all selected frequencies $f_i$ by making only one first, second and third measurement and only one calculation. It is also possible to determine the phase distortion φ for each of the selected frequencies $f_i$ consecutively. In this case the in-phase and the quadrature-phase signal $Y_{IP}(t)$ and $Y_{QP}(t)$ comprise only one spectral line of the selected spectral lines of the distorted response signal $Y_R(t)$ with the frequency $f_i$, at which the phase distortion φ will be determined in the following calculation. In the following second and third measurement only the amplitudes $M_i$ and $M_q$ of one spectral line of the signal $Y_i(t)$ and $Y_q(t)$ created by addition of the distorted response signal $Y_R(t)$ and the in-phase signal $Y_{IP}(t)$ and the quadrature-phase signal $Y_{QP}(t)$ respectively, with the corresponding frequency $f_i$ will be measured. In step S70 and S80 the x coordinate $S_x$, the y coordinate $S_Y$ and the phase distortion φ are calculated for only one frequency $f_i$. For determining the phase distortion φ at all selected frequencies $f_i$ the steps S30, S40, S50, S60, S70, S80 and S90 of the inventive method are performed repeatedly for each of the selected frequencies $f_i$.

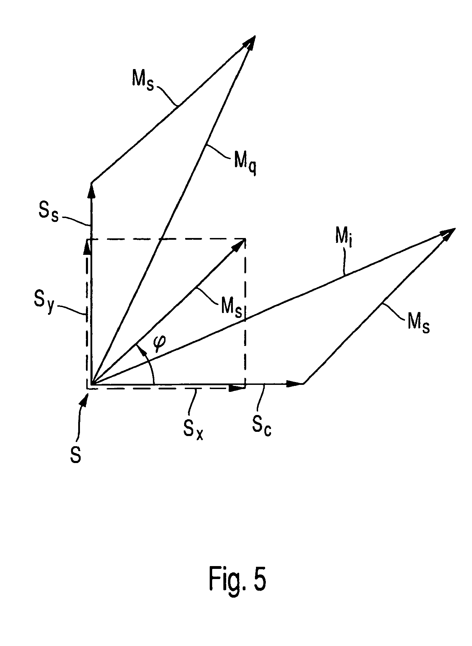

The mathematical relations between the x coordinate $S_x$ and the y coordinate $S_Y$ of the distorted response signal $Y_R(t)$ in the coordinate system S created by the in-phase signal $Y_{IP}(t)$ and the quadrature-phase signal $Y_{QP}(t)$ and the amplitudes $M_s$, $M_i$ and $M_q$ of the signals $Y_R(t)$, $Y_i(t)$ and $Y_q(t)$ measured by means of a spectrum analyser 13 of the inventive apparatus are displayed in Fig. 5 exemplarily for one selected frequency $f_i$. Since the amplitude of each spectral line is different, similar but different vector diagrams have to be applied to each individual spectral line. The mathematical derivation of the x coordinate $S_x$ and the y coordinate $S_Y$ of each spectral line of the distorted response signal $Y_R(t)$ in the orthogonal coordinate system S is identical.

The phase shift φ of the distorted response signal $Y_R(t)$ with its amplitude $M_s$ against the in-phase signal $Y_{IP}(t)$ with its amplitude $S_c$ representing the x coordinate axis of the orthogonal coordinate system S is characterised by the phase angle φ. The measured amplitude of the signal $Y_i(t)$ generated by the addition of the in-phase signal $Y_{IP}(t)$ and the distorted response signal $Y_R(t)$ is $M_i$. The amplitude of the quadrature-phase signal $Y_{QP}(t)$ representing the y coordinate axis of the orthogonal coordinate system S is $S_s$. The measured amplitude of the signal $Y_q(t)$ generated by the addition of the quadrature-phase signal $Y_{QP}(t)$ and the distorted response signal $Y_R(t)$ is $M_q$.

The distorted response signal $Y_R(t)$ with its amplitude $M_S$ can be described in complex presentation by its x coordinate $S_x$ and its y coordinate $S_Y$ according to equation (4):

$$M_s = S_x + j\, S_Y \qquad (4)$$

The complex presentation of the signal $Y_i(t)$ generated by the addition of the distorted response signal $Y_R(t)$ and the in-phase signal $Y_{IP}(t)$ with its amplitude $M_i$ is shown in equation (5), whereas the complex presentation of the signal $Y_q(t)$ generated by the addition of the distorted response signal $Y_R(t)$ and the quadrature-phase signal $Y_{QP}(t)$ with its amplitude $M_q$ is shown in equation (6):

$$M_i = (S_x + S_c) + j\, S_Y \qquad (5)$$

$$M_q = S_x + j (S_Y + S_s) \tag{6}$$

The magnitude squared of these signals is presented in equations (7), (8) and (9):

$$M_s^2 = S_x^2 + S_Y^2 \tag{7}$$

$$M_i^2 = (S_x + S_c)^2 + S_Y^2 \tag{8}$$

$$M_q^2 = S_x^2 + (S_Y + S_s)^2 \tag{9}$$

Subtracting $M_s^2$ from $M_i^2$ leads to equation (10), whereas subtracting $M_s^2$ from $M_q^2$ leads to equation (11):

$$M_i^2 - M_s^2 = 2 * S_x * S_c + S_c^2 \tag{10}$$

$$M_q^2 - M_s^2 = 2 * S_Y * S_s + S_s^2 \tag{11}$$

The mathematical expression for calculating the x coordinate $S_x$ of the distorted response signal $Y_R(t)$ in the orthogonal coordinate system S according equation (1) can be derived by mathematical transformation of equation (10), whereas the mathematical expression for calculating the y coordinate $S_Y$ of the distorted response signal $Y_R(t)$ in the orthogonal coordinate system S according to equation (2) can be derived by mathematical transformation of equation (11).

For selecting appropriate frequencies $f_i$ in the inventive apparatus and in the inventive method for determining the phase distortion $\varphi$ caused by a device under test 6 the appearance of additional spectral lines in the distorted response signal $Y_R(t)$ in comparison to the reference signal $Y_T(t)$ has to be understood. Therefore a model explaining the occurrence of additional spectral lines in the distorted response signal $Y_R(t)$ caused by the nonlinearity of the device under test 6 is introduced in the following:

A nonlinear distorted response signal $Y(t)$ caused by a device under test provided with a test signal $X(t)$ is modelled by a higher order polynomial according to equation (12):

$$Y(t) = a_0 + a_1 X(t) + a_2 X(t)^2 + a_3 X(t)^3 + a_4 X(t)^4 + a_5 X(t)^5 + .... \tag{12}$$

The harmonic distortion components $a_i$ ($0 <= i < n$) can be determined by measuring the amplitudes of the spectral lines of the response signal and subsequent calculating - comparison of the coefficients - as shown in the following. Assuming that the device under test is reasonably linear, the harmonic distortion components above the 5th harmonic are comparably small and thus can be ignored.

Considering firstly an amplifier as device under test, where two signals $X_1$ and $X_2$ are contemporaneously used as input test signal. This input test signal is closely related to a signal generated by means of a mixer, where a single tone is up-converted to produce a double sideband suppressed carrier spectrum.

The distorted response signal of an amplifier can be described by addition of the two signals $X_1(t)$ and $X_2(t)$ according to equation (13):

$$Y(t) = a_0 + a_1[X_1(t) + X_2(t)] + a_2[X_1(t) + X_2(t)]^2 + a_3[X_1(t) + X_2(t)]^3 + a_4[X_1(t) + X_2(t)]^4 + a_5[X_1(t) + X_2(t)]^5 + .... \tag{13}$$

Assuming $X_1(t)=Sin(\omega_1 t)$ and $X_2(t)=Sin(\omega_2 t)$ and applying the following algebraical relations to equations (14) to (17):

$$(A+B)^2 = A^2 + 2AB + B^2 \qquad (14)$$

$$(A+B)^3 = A^3 + 3A^2B + 3AB^2 + B^3 \qquad (15)$$

$$(A+B)^4 = A^4 + 4A^3B + 6A^2B^2 + 4AB^3 + B^4 \qquad (16)$$

$$(A+B)^5 = A^5 + 5A^4B + 10A^3B^2 + 10A^2B^3 + 5AB^4 + B^5 \qquad (17)$$

results in the expression in equation (18) for the distorted response signal Y(t) considering only spectral lines around the fundamental frequencies of $F_1$ and $F_2$:

$$Y(t) = a_1 \left[ X_1(t) + X_2(t) \right] + a_3 \left[ X_1(t)^3 + 3X_1(t)^2 X_2(t) + 3X_1(t)X_2(t)^2 + X_2(t)^3 \right] +$$
$$+ a_5 \left[ X_1(t)^5 + 5X_1(t)^4 X_2(t) + 10X_1(t)^3 X_2(t)^2 + 10X_1(t)^2 X_2(t)^3 + 5X_1(t)X_2(t)^4 + X_2(t) \right]^5 + ....$$

$$(18)$$

The problematic spectral lines around the fundamental frequencies $F_1$ and $F_2$ are created by odd order intermodulation distortion components (3IM, SIM, 7IM etc.) as shown in equation (18). The unproblematic even order intermodulation distortion components (2IM, 4IM, 6IM etc.) positioning at higher frequencies can be filtered out very easily in comparison to the odd order intermodulation distortion components and thus will be neglected in the following.

Applying the trigonometrical relations in equations (19) to (22) to the expression for the distorted response signal Y(t) in equation (18):

$$Sin(\alpha)^2 = \frac{1}{2} + \frac{1}{2}Sin(2\alpha) \qquad (19)$$

$$Sin(\alpha)^3 = \frac{3}{4}Sin(\alpha) + \frac{1}{4}Sin(3\alpha) \qquad (20)$$

$$Sin(\alpha)^4 = \frac{3}{8} + \frac{1}{2}Sin(2\alpha) + \frac{1}{8}Sin(4\alpha) \qquad (21)$$

$$Sin(\alpha)^5 = \frac{5}{8}Sin(\alpha) + \frac{5}{16}Sin(3\alpha) + \frac{1}{16}Sin(5\alpha) \qquad (22)$$

results in spectral line amplitudes of the distorted response signal Y(t) at the fundamental frequencies $F_1$ and $F_2$ combined in the expression $Y_P$ in equation (23):

$$Y_F = a_1 + (\frac{3}{4} + 3\frac{1}{2})a_3 + (\frac{5}{8} + 10\frac{3}{8} + 5\frac{3}{8})a_5 = a_1 + \frac{9}{4}a_3 + \frac{25}{4}a_5 \tag{23}$$

in spectral line amplitudes around the fundamental frequencies $F_1$ and $F_2$ at frequencies $\pm 2F_1 \pm F_2$ and $\pm F_1 \pm 2F_2$ (3rd order intermodulation distortion components 3IMu and 3Imo) combined in the expression $Y_{3M}$ in equation (24):

$$Y_{3IM} = \frac{3}{4}a_3 + \frac{1}{2}(5\frac{1}{2} + 10\frac{3}{8})a_5 = \frac{3}{4}a_3 + \frac{25}{8}a_5 \tag{24}$$

and in spectral line amplitudes around the fundamental frequencies $F_1$ and $F_2$ at frequencies $\pm 3F_1 \pm 2F_2$ and $\pm 2F_1 \pm 3F_2$ (5th order intermodulation distortion components 5IMu and 5Imo) combined in the expression $Y_{5M}$ in equation (25) :

$$Y_{5IM} = \frac{1}{2}10\frac{1}{8}a_5 = \frac{5}{8}a_5 \tag{25}$$

The third order IM (3IM) is thus also dependent on the 5th harmonic distortion component $a_5$. The effect of the 5th harmonic is 5 times bigger on the 3IM component than on the 5IM component.

The distorted response signal of a mixer as device under test can be described by multiplication of the modulation signal $X_m(t)$ according to equation (26) and the carrier signal of a local oscillator $X_{LO}(t)$ according to equation (27):

$$Y_m(t) = a_0 + a_1 X_m(t) + a_2 X_m(t)^2 + a_3 X_m(t)^3 + a_4 X_m(t)^4 + a_5 X_m(t)^5 + .... \tag{26}$$

$$Y_{LO}(t) = b_0 + b_1 X_{LO}(t) + b_2 X_{LO}(t)^2 + b_3 X_{LO}(t)^3 + b_4 X_{LO}(t)^4 + b_5 X_{LO}(t)^5 + .... \tag{27}$$

Assuming $X_m(t) = Sin(2\pi Ft)$ and $X_{LO}(t) = Sin(2\pi Lt)$ the resulting spectral lines of the distorted response caused by the mixer as device under test are displayed in Table 1. The first section of table 1 contains the harmonics of the modulation signal $X_m(t)$ multiplied with the DC component ($b_0$) of the carrier signal $X_{LO}(t)$, the second section of table 1 contains the intermodulation distortion components created by mixing the harmonics of the modulation signal $X_m(t)$ with the fundamental component ($b_1 Sin(2\pi Lt)$) of the carrier signal $X_{LO}(t)$ and the third and the fourth section of table 1 contains the intermodulation distortion components created by mixing the harmonics of the modulation signal $X_m(t)$ with the second harmonic ($b_2 Sin(2\pi 2Lt)$) and the third harmonic ($b_3 Sin(2\pi 3Lt)$) of the carrier signal $X_{LO}(t)$ respectively:

Table 1. Spectral lines produced by a mixer.

| DC-components: | | | | | | | | | | | |
|---|---|---|---|---|---|---|---|---|---|---|---|
| Name | X5u | X4u | X3u | X2u | Xu | DC | Xo | 2Xo | 3Xo | 4X0 | X5o |
| Freq | -5*F | -4*F | -3*F | -2*F | -F | DC | F | 2*F | 3*F | 4*F | 5*F |
| Products | $a_5b_0$ | $a_4b_0$ | $a_3b_0$ | $a_2b_0$ | $a_1b_0$ | $a_0b_0$ | $a_1b_0$ | $a_2b_0$ | $a_3b_0$ | $a_4b_0$ | $a_5b_0$ |
| Fundamentals: | | | | | | | | | | | |
| Name | 5IMu | 4IMu | 3IMu | 2IMu | Fu | LO | Fo | 2IMo | 3IMo | 4IMo | 5IMo |
| Freq | L-5*F | L-4*F | L-3*F | L-2*F | L-F | L | L+F | L+2*F | L+3*F | L+4*F | L+5*F |
| Products | $a_5b_1$ | $a_4b_1$ | $a_3b_1$ | $a_2b_1$ | $a_1b_1$ | $a_0b_1$ | $a_1b_1$ | $a_2b_1$ | $a_2b_1$ | $a_4b_1$ | $a_5b_1$ |

(continued)

| 2nd Harmonics: | | | | | | | | | | | |
|---|---|---|---|---|---|---|---|---|---|---|---|
| Name | 2IM5u | 2IM4u | 2IM3u | 2IM2u | 2Fu | 2LO | *2Fo* | 2IM2o | 2IM3o | 2IM4o | 2IM5o |
| Freq | $2*L-5*F$ | $2*L-4*F$ | $2*L-3*F$ | $2*L-2*F$ | $2*L-F$ | $2*L$ | $2*L+F$ | $2*L+2*F$ | $2*L+3*F$ | $2*L+4*F$ | $2*L+5*F$ |
| Products | $a_5b_2$ | $a_4b_2$ | $a_3b_2$ | $a_2b_2$ | $a_1b_2$ | $a_0b_2$ | $a_1b_2$ | $a_2b_2$ | $a_3b_2$ | $a_4b_2$ | $a_5b_2$ |
| 3rd Harmonics: | | | | | | | | | | | |
| Name | *3IM5u* | 3IM4u | *3IM3u* | *3 IM2u* | 3Fu | 3LO | *3Fo* | *3IM2o* | *3IM3o* | 3IM4o | *3IM5o* |
| Freq | $3*L-5*F$ | $3*L-4*F$ | $3*L-3*F$ | $3*L-2*F$ | $3*L-F$ | $3*L$ | $3*L+F$ | $3*L+2*F$ | $3*L+3*F$ | $3*L+4*F$ | $3*L+5*F$ |
| Products | $a_5b_3$ | $a_4b_3$ | $a_3b_3$ | $a_2b_3$ | $a_1b_3$ | $a_0b_3$ | $a_1b_3$ | $a_2b_3$ | $a_3b_3$ | $a_4b_3$ | $a_5b_3$ |

The amplitudes of those spectral lines written in italic letters in Table 1 are the larger ones, which must be respected in the following considerations.

In practice the components around DC and those around the 2nd and 3rd harmonic do not directly cause any problem in communication systems and these components will not directly cause components to emerge close to the carrier and will this not effect the Adjacent Channel Power Ratio (ACPR).

Table 2 contains spectral lines of a response signal distorted by a power amplifier, whose input is provided with a response signal distorted by the above described mixer respecting only spectral lines with larger amplitudes (spectral lines in Table 1 written in italic letters):

Table 2. Additional frequency components produced by the nonlinearity of an amplifier.

| Name | IM5u | IM4u | IM3u | IM2u | Fu | LO | Fo | IM2o | IM3o | IM4o | IM5o |
|---|---|---|---|---|---|---|---|---|---|---|---|
| Freq | L-3*F | | L -2*F | | L-F | L | L+F | | L + 2*F | | L + 2*F |
| DC*Fundamental: | | | | | | | | | | | |
| Products | | XuIM3u | XuIM2u | XuFu | | *XuFo* | XuIM2o | XuIM3o | | XuIM5o | |
| Products | | XoIM5u | | XoIM3u | XoIM2u | *XoFu* | | *XoFo* | XoIM2o | XoIM3o | |
| Products | | 3XuFu | 2XuFu | | | | 2XoFu | 3XoFu | | | |
| Products | | | | 3XuFo | 2XuFo | | | | 2XoFu | 3XoFu | |
| 2ndHarm*fundamentals: | | | | | | | | | | | |
| Products | | | | *2FuFu* | | *2FuFo* | | | *2FuFu* | | |
| Products | | | | | | *2FoFu* | | | | | |
| 2ndHarmonic*Third Harmonics: | | | | | | | | | | | |
| Products | | | | *2Fu3Fu* | | *2Fu3Fo* | | | | | |
| Prod cts | | | | | | *2Fo3Fu* | | | | *2Fu3Fu* | |

The amplitudes of the spectral lines written in italic letters in Table 2 are the larger ones which must be considered when selecting appropriate frequencies $f_i$ for the measuring of the phase distortion $\varphi$.

The mixer is driven by a local oscillator which is a squarewave; as a result the third, fifth etc harmonic frequency components of the local oscillator will be large and must be considered in the subsequent power amplifier distortion model. These harmonics and the components around DC will generate unwanted intermodulation distortion components, which will appear in the fundamental spectrum region. To minimize these components, firstly the DC components produced by the mixer should be minimized and secondly the even harmonics of the local oscillator, i.e. the $2^{nd}$, $4^{th}$, $6^{th}$ etc harmonic signals of the local oscillator should be minimized.

For obtaining clear relations between the amplitudes of the spectral lines of the test signal $Y_T(t)$ and the amplitudes $M_s$, $M_i$ and $M_q$ of the spectral lines of the measured signals $Y_R(t)$, $Y_i(t)$ and $Y_q(t)$ for each selected frequency $f_i$ those frequencies $f_i$ have to be selected at which only one spectral line is positioned. In this case the phase distortion $\varphi$ at the selected frequency $f_i$ is not falsified by superpositioning of spectral lines caused by different intermodulation distortion components.

While the invention has been shown and described with reference to the above displayed embodiment thereof, it will be understood by those skilled in the art that various changes in form and details may be made therein without departing from the scope of the invention as defined by the appended claims.

**Claims**

1. A method of determining the phase distortion $\varphi$ caused by a device under test (6) comprising the steps:

    referencing (S100) the phase of a distorted response signal $Y_R(t)$ of said device under test (6) provided with a reference signal $Y_T(t)$ to a coordinate system (S) being in phase with said reference signal $Y_T(t)$,
    measuring (200) a first amplitude $M_S$ of a first signal $Y_R(t)$, a second amplitude $M_i$ of a second signal $Y_i(t)$ and a third amplitude $M_q$ of a third signal $Y_q(t)$ depending on signals $Y_{IP}(t)$, $Y_{QP}(t)$ characterising the two coordinate axes of said coordinate system (S), on said distorted response $Y_R(t)$ signal and/or on said reference signal $Y_T(t)$, calculating (S80) the two coordinates $S_X$, $S_Y$ of said distorted response signal $Y_R(t)$ in said coordinate system (S) on the basis of said measured amplitudes $M_s$, $M_i$ and $M_q$ and
    determining (S90) said phase distortion $\varphi$ by calculating said phase on the basis of said two coordinates $S_X$, $S_Y$,

    wherein said coordinate system (S) is an orthogonal coordinate system (S), said two coordinate axes being the x coordinate axis and the y coordinate axis and said two coordinates $S_X$ and $S_Y$ being the x coordinate and the y coordinate,
    wherein said signals $Y_{IP}(t)$, $Y_{QP}(t)$ characterising the x and y coordinate axes are a pair of quadrature signals,
    wherein said pair of quadrature signals is an in-phase-signal $Y_{IP}(t)$ and a quadrature-phase signal $Y_{QP}(t)$ and
    wherein said several signals $Y_R(t)$, $Y_i(t)$ and $Y_q(t)$ are said distorted response $Y_R(t)$ signal measured in a first measurement ($M_S$), a signal $Y_i(t)$ generated by addition of said distorted response signal $Y_R(t)$ and said in-phase signal $Y_{IP}(t)$ measured in a second measurement ($M_i$) and a signal $Y_q(t)$ generated by addition of said distorted response signal $Y_R(t)$ and said quadrature-phase signal $Y_{QP}(t)$ measured in a third measurement ($M_q$).

2. A method of determining the phase distortion $\varphi$ according to claim 1,
    wherein said distorted response signal $Y_R(t)$ in said first, second and third measurement is caused by providing said device under test (6) with the same reference signal $Y_T(t)$ being a baseband signal with at least one spectral line.

3. A method of determining the phase distortion $\varphi$ according to claim 1 or 2,
    wherein frequencies $f_i$, at which said phase distortion $\varphi$ is determined, are determined by selection of frequencies of spectral lines of said distorted response signal $Y_R(t)$ in said first measurement.

4. A method of determining the phase distortion $\varphi$ according to claim 3,
    wherein said in-phase and said quadrature-phase signal $Y_{IP}(t)$, $Y_{QP}(t)$ each comprises in total said spectral lines of said distorted response signal $Y_R(t)$ at said selected frequencies $f_i$ with said amplitudes $M_s$ measured in said first measurement and wherein said first, second and third measurement for determining said phase distortion $\varphi$ at said selected frequencies $f_i$ are performed once.

5. A method of determining the phase distortion $\varphi$ according to claim 3,
    wherein said second and said third measurement is separately performed for each of said selected frequencies $f_i$, whereby said in-phase and said quadrature-phase signal $Y_{IP}(t)$, $Y_{QP}(t)$ comprise only one spectral line of said selected spectral lines of said distorted response signal $Y_R(t)$ with said corresponding frequency and said corresponding amplitude $M_s$ measured in said first measurement.

**6.** A method of determining the phase distortion $\varphi$ according to claim 4 or 5,
wherein said phase distortion $\varphi$ at said selected frequencies $f_i$ is calculated by the equation:

$$\varphi = \texttt{arctan}((M_q^2-M_s^2-S_s^2)*S_c/((M_i^2-M_s^2-S_c^2)*S_s))$$

whereas

$M_s$ is said amplitude of said distorted response signal $Y_R(t)$ at said selected frequencies $f_i$,
$M_i$ is said amplitude of said signal $Y_i(t)$ generated by addition of said distorted response signal $Y_R(t)$ and said in-phase signal $Y_{IP}(t)$ at said selected frequencies $f_i$,
$M_q$ is said amplitude of said signal $Y_q(t)$ generated by addition of said distorted response signal $Y_R(t)$ and said quadrature-phase signal $Y_{QP}(t)$ at said selected frequencies $f_i$,
$S_c$ is said amplitude of said in-phase signal $Y_{IP}(t)$ at said selected frequencies $f_i$ and
$S_s$ is said amplitude of said quadrature-phase signal $Y_{QP}(t)$ at said selected frequencies $f_i$.

**7.** An apparatus for determining the phase distortion $\varphi$ caused by a device under test (6) comprising
a waveform generator (1, 3) for generating a test signal $Y_T(t)$, an in-phase signal $Y_{IP}(t)$ and a quadrature-phase signal $Y_{QP}(t)$ and a spectrum analyser (13) for successively measuring a distorted response signal $Y_R(t)$ caused by a device under test (6) provided with said test signal $Y_T(t)$, a signal $Y_i(t)$ generated by addition of said distorted response signal $Y_R(t)$ and said in-phase signal $I_P(t)$ and a signal $Y_q(t)$ generated by addition of said distorted response signal $Y_R(t)$ and said quadrature-phase signal $Y_{QP}(t)$,
wherein said in-phase signal $Y_{IP}(t)$ and said quadrature-phase signal $Y_{QP}(t)$ depend on said distorted response signal $Y_R(t)$,
wherein the phase of said in-phase signal $Y_{IP}(t)$ is reference-phased to the phase of said test signal $Y_T(t)$,
wherein the phase of said quadrature-phase signal $Y_{QP}(t)$ is quadrature-phased to the phase of said in-phase signal $Y_{IP}(t)$ and
wherein said waveform generator (1,3) comprises a first waveform generator (1) generating said test signal $Y_T(t)$ and a second waveform generator (3) generating said in-phase and said quadrature-phase signal $Y_{IP}(t)$, $Y_{QP}(t)$, the apparatus further comprising
a control system (3) for synchronising said phase of said in-phase and said quadrature-phase signal $Y_{IP}(t)$, $Y_{QP}(t)$ in said first waveform generator (1) to said phase of said test signal $Y_T(t)$ in said second waveform generator (3) and
a calculation unit (14) for calculating said phase distortion $\varphi$ caused by said device under test (6) on the base of a first measured amplitude $M_S$ of said distorted response signal $Y_R(t)$, of a second measured amplitude $M_i$ of said signal $Y_i(t)$
and of a third measured amplitude $M_q$ of said signal $Y_q(t)$.

**8.** An apparatus for determining the phase distortion $\varphi$ caused by a device under test according to claim 7,
wherein said first waveform generator (1, 3) is an arbitrary waveform generator generating OFDM-like reference signals $Y_T(t)$.

**9.** An apparatus for determining the phase distortion $\varphi$ caused by a device under test according to claim 7 or 8,
wherein said device under test (6) has a nonlinear transfer behaviour leading to higher order spectral lines and intermodulation spectral lines in said distorted response signal $Y_R(t)$.

**10.** An apparatus for determining the phase distortion $\varphi$ caused by a device under test according to any of claims 7 to 9,
wherein said spectrum analyser (13) is a scalar-type spectrum analyser.

**Patentansprüche**

**1.** Verfahren zur Ermittlung der Phasenverzerrung $\varphi$, die durch eine zu testende Anordnung (6) verursacht wird, umfassend die Schritte: Referenzieren (S 100) der Phase eines verzerrten Antwortsignals $Y_R(t)$ der zu testenden Anordnung (6), die mit einem Referenzsignal $Y_T(t)$ beaufschlagt wurde, auf ein Koordinatensystem (S), welches mit dem Referenzsignal $Y_T(t)$ in Phase ist,

Messen (S200) einer ersten Amplitude $M_S$ eines ersten Signals $Y_R(t)$, einer zweiten Amplitude $M_i$ eines zweiten Signals $Y_i(t)$ und einer dritten Amplitude $M_q$ eines dritten Signals $Y_q(t)$, die von Signalen $Y_{IP}(t)$, $Y_{QP}(t)$, die die zwei Koordinatenachsen des Koordinatensystems (S) kennzeichnen, von dem verzerrten Antwortsignal $Y_R(t)$ und/oder von dem Referenzsignal $Y_T(t)$ abhängig sind,

Berechnen (S80) der zwei Koordinaten $S_X$, $S_Y$ des verzerrten Antwortsignals $Y_R(t)$ in dem Koordinatensystem (S) auf Grundlage der gemessenen Amplituden $M_s$, $M_i$ und $M_q$ und

Ermitteln (S90) der Phasenverzerrung $\varphi$ durch Berechnen der Phase auf der Grundlage der zwei Koordinaten $S_X$, $S_Y$, wobei das Koordinatensystem (S) ein orthogonales Koordinatensystem (S) ist, und wobei die zwei Koordinatenachsen die x-Koordinatenachse und die y-Koordinatenachse sind und die zwei Koordinaten $S_X$ und $S_Y$ die x-Koordinate und die y-Koordinate sind,

wobei die Signale $Y_{IP}(t)$, $Y_{QP}(t)$, die die x- und y-Koordinatenachsen kennzeichnen, ein Paar von Quadratursignalen sind,

wobei das Paar von Quadratursignalen aus einem In-Phase-Signal- $Y_{IP}(t)$ und einem Quadratur-Phase-Signal-$Y_{QP}(t)$ besteht und

wobei die verschiedenen Signale $Y_R(t)$, $Y_i(t)$ und $Y_q(t)$ das verzerrte Antwortsignal $Y_R(t)$, das in einer ersten Messung $(M_S)$ gemessen wurde, ein Signal $Y_i(t)$, das durch Addition des verzerrten Antwortsignals $Y_R(t)$ und dem In-Phase-Signal- $Y_{IP}(t)$, das in einer zweiten Messung $(M_i)$ gemessen wurde, erzeugt wurde, und ein Signal $Y_q(t)$, das durch Addition des verzerrten Antwortsignals $Y_R(t)$ und dem Quadratur-Phase-Signal-$Y_{QP}(t)$, das in einer dritten Messung $(M_q)$ gemessen wurde, erzeugt wurde, sind.

2. Verfahren zur Ermittlung der Phasenverzerrung $\varphi$ nach Anspruch 1,
   wobei das verzerrte Antwortsignal $Y_R(t)$ in der ersten, der zweiten und der dritten Messung verursacht wird, indem die zu testende Anordnung mit dem gleichen Referenzsignal $Y_T(t)$ beaufschlagt wird, das ein Basisbandsignal mit zumindest einer Spektrallinie ist.

3. Verfahren zur Ermittlung der Phasenverzerrung $\varphi$ nach Anspruch 1 oder 2,
   wobei Frequenzen $f_i$, bei denen die Phasenverzerrung $\varphi$ ermittelt wird, durch Auswahl der Frequenzen von Spektrallinien des verzerrten Antwortsignals $Y_R(t)$ in der ersten Messung bestimmt werden.

4. Verfahren zur Ermittlung der Phasenverzerrung $\varphi$ nach Anspruch 3,
   wobei das In-Phase- und das Quadratur-Phase-Signal $Y_{IP}(t)$, $Y_{QP}(t)$ jeweils vollständig die Spektrallinien des verzerrten Antwortsignals $Y_R(t)$ bei den ausgewählten Frequenzen $f_i$ mit den Amplituden $M_s$, die in der ersten Messung gemessen wurden, umfassen, und wobei die erste, die zweite und die dritte Messung zur Ermittlung der Phasenverzerrung $\varphi$ bei den ausgewählten Frequenzen $f_i$ einmal durchgeführt werden.

5. Verfahren zur Ermittlung der Phasenverzerrung $\varphi$ nach Anspruch 3,
   wobei die zweite und die dritte Messung getrennt für jede der ausgewählten Frequenzen $f_i$ durchgeführt werden, wodurch das In-Phase- und das Quadratur-Phase-Signal $Y_{IP}(t)$, $Y_{QP}(t)$ lediglich eine Spektrallinie der ausgewählten Spektrallinien des verzerrten Antwortsignals $Y_R(t)$ mit der korrespondierenden Frequenz und der korrespondierenden Amplitude $M_s$, die in der ersten Messung gemessen wurde, umfassen.

6. Verfahren zur Ermittlung der Phasenverzerrung $\varphi$ nach Anspruch 4 oder 5,
   wobei die Phasenverzerrung $\varphi$ bei den ausgewählten Frequenzen $f_i$ berechnet wird durch die Gleichung:

$$\varphi = \arctan\left((M_q^2 - M_s^2 - S_s^2)^* S_c / ((M_i^2 - M_s^2 - S_c^2)^* S_s)\right)$$

wobei

$M_s$ die Amplitude des verzerrten Antwortsignals $Y_R(t)$ bei den ausgewählten Frequenzen $f_i$ ist,
$M_i$ die Amplitude des Signals $Y_i(t)$ ist, das durch Addition des verzerrten Antwortsignals $Y_R(t)$ und des In-Phase-Signals $Y_{IP}(t)$ bei den ausgewählten Frequenzen $f_i$ erzeugt wurde,
$M_q$ die Amplitude des Signals $Y_q(t)$ ist, das durch Addition des verzerrten Antwortsignals $Y_R(t)$ und des Quadratur-Phase-Signals $Y_{QP}(t)$ bei den ausgewählten Frequenzen $f_i$ erzeugt wurde,
$S_c$ die Amplitude des In-Phase-Signals $Y_{IP}(t)$ bei den ausgewählten Frequenzen $f_i$ ist und
$S_s$ die Amplitude des Quadratur-Phase-Signals $Y_{QP}(t)$ bei den ausgewählten Frequenzen $f_i$ ist.

**7.** Vorrichtung zur Ermittlung der Phasenverzerrung φ, die von einer zu testenden Anordnung (6) verursacht wurde, umfassend

einen Frequenzgeber (1, 3) zur Erzeugung eines Testsignals $Y_T(t)$ eines In-Phase-Signals $Y_{IP}(t)$ und eines Quadratur-Phase-Signals $Y_{QP}(t)$

und einen Spektrum-Analysator (13), um sukzessive ein verzerrtes Antwortsignal $Y_R(t)$ zu messen, das durch eine zu testende Anordnung (6) verursacht wurde, die mit dem Testsignal $Y_T(t)$, einem Signal $Y_i(t)$, das durch Addition des verzerrten Antwortsignals $Y_R(t)$ und dem In-Phase-Signal $Y_{IP}(t)$ erzeugt wurde, und mit einem Signal $Yq(t)$, das durch Addition des verzerrten Antwortsignals $Y_R(t)$ und des Quadratur-Phase-Signals $Y_{QP}(t)$ erzeugt wurde, beaufschlagt wurde,

wobei das In-Phase-Signal $Y_{IP}(t)$ und das Quadratur-Phase-Signal $Y_{QP}(t)$ von dem verzerrten Antwortsignal $Y_R(t)$ abhängig sind,

wobei die Phase des In-Phase-Signal $Y_{IP}(t)$ referenzphasig zu der Phase des Testsignals $Y_T(t)$ ist,

wobei die Phase des Quadratur-Phase-Signals $Y_{QP}(t)$ quadraturphasig zu der Phase des In-Phase-Signal $Y_{IP}(t)$ ist und

wobei der Frequenzgenerator (1, 3) einen ersten Frequenzgenerator (1), der das Testsignal $Y_T(t)$ erzeugt, und einen zweiten Frequenzgenerator (3), der das In-Phase- und das Quadratur-Phase-Signal $Y_{IP}(t)$, $Y_{QP}(t)$ erzeugt, umfasst,

und wobei die Vorrichtung ferner umfasst

ein Steuersystem (3) zur Phasensynchronisierung des In-Phase- und des Quadratur-Phase-Signals $Y_{IP}(t)$, $Y_{QP}(t)$ in dem ersten Frequenzgenerator (1) zu der Phase des Testsignals $Y_T(t)$ in dem zweiten Frequenzgenerator (3) und eine Berechnungseinheit (14) zur Berechnung der Phasenverzerrung φ, die durch die zu testende Anordnung (6) verursacht wird, auf Grundlage einer ersten gemessenen Amplitude $M_s$ des verzerrten Antwortsignals $Y_R(t)$ einer zweiten gemessenen Amplitude $M_i$ des Signals $Y_i(t)$ und einer dritten gemessenen Amplitude $M_q$ des Signals $Y_q(t)$.

**8.** Vorrichtung zur Ermittlung einer Phasenverzerrung φ, die durch eine zu testende Vorrichtung verursacht wurde, nach Anspruch 7,

wobei der erste Frequenzgenerator (1, 3) ein arbiträrer Frequenzgenerator ist, der OFDM-ähnliche Referenzsignale $Y_T(t)$ erzeugt.

**9.** Vorrichtung zur Ermittlung der Phasenverzerrung φ, die durch eine zu testende Anordnung verursacht wurde, nach Anspruch 7 oder 8,

wobei die zu testende Anordnung (6) ein nichtlineares Transferverhalten aufweist, das zu Spektrallinien höherer Ordnung und zu Intermodulationsspektrallinien in dem verzerrten Antwortsignal $Y_R(t)$ führt.

**10.** Vorrichtung zur Ermittlung der Phasenverzerrung φ, die durch eine zu testende Anordnung verursacht wurde, nach einem der Ansprüche 7 bis 9,

wobei der Spektrumanalysator (13) ein Spektrumanalysator des Scalar-Typs ist.

**Revendications**

**1.** Procédé pour déterminer la distorsion de phase φ causée par un dispositif en cours de test (6) comprenant les étapes :

référencer (S100) la phase d'un signal de réponse distordu $Y_R(t)$ dudit dispositif en cours de test (6) prévu avec un signal de référence $Y_\tau(t)$ par rapport à un système de coordonnées (S) étant en phase avec ledit signal de référence $Y_\tau(t)$,

mesurer (200) une première amplitude $M_s$ d'un premier signal $Y_R(t)$, une deuxième amplitude $M_i$ d'un deuxième signal $Y_i(t)$ et une troisième amplitude $M_q$ d'un troisième signal $Y_q(t)$ dépendant de signaux $Y_{IP}(t)$, $Y_{QP}(t)$ caractérisant les deux axes de coordonnées dudit système de coordonnées (S), sur ledit signal de réponse distordu $Y_R(t)$ et/ou sur ledit signal de référence $Y_\tau(t)$,

calculer (S80) les deux coordonnées $S_x$, $S_y$ dudit signal de réponse distordu $Y_R(t)$ dans ledit système de coordonnées (S) sur la base desdites amplitudes $M_s$, $M_i$ et $M_q$ mesurées et

déterminer (S90) ladite distorsion de phase φ en calculant ladite phase sur la base desdites deux coordonnées $S_x$, $S_y$,

dans lequel ledit système de coordonnées (S) est un système de coordonnées orthogonales (S), lesdits deux axes de coordonnées étant l'axe des coordonnées x et l'axe des coordonnées y et lesdites deux coordonnées $S_x$ et $S_y$ étant la coordonnée x et la coordonnée y,

dans lequel lesdits signaux $Y_{IP}(t)$, $Y_{QP}(t)$ caractérisant les axes de coordonnées x et y sont une paire de signaux en quadrature,

dans lequel ladite paire de signaux en quadrature sont un signal en phase $Y_{IP}(t)$ et un signal de phase en quadrature $Y_{QP}(t)$ et

dans lequel lesdits plusieurs signaux $Y_R(t)$, $Y_i(t)$ et $Y_q(t)$ sont ledit signal de réponse distordu $Y_R(t)$ mesuré dans une première mesure ($M_S$), un signal $Y_i(t)$ généré par addition dudit signal de réponse distordu $Y_R(t)$ et dudit signal en phase $Y_{IP}(t)$ mesuré dans une deuxième mesure ($M_i$) et un signal $Y_q(t)$ généré par addition dudit signal de réponse distordu $Y_R(t)$ et dudit signal de phase en quadrature $Y_{QP}(t)$ mesuré dans une troisième mesure (Mq).

2. Procédé pour déterminer la distorsion de phase $\varphi$ selon la revendication 1,
dans lequel ledit signal de réponse distordu $Y_R(t)$ dans lesdites première, deuxième et troisième mesures est causé en fournissant audit dispositif en cours de test (6) le même signal de référence $Y_\tau(t)$ étant un signal dans la bande de base avec au moins une raie spectrale.

3. Procédé pour déterminer la distorsion de phase $\varphi$ selon la revendication 1 ou 2,
dans lequel des fréquences $f_i$, auxquelles ladite distorsion de phase $\varphi$ est déterminée, sont déterminées par une sélection de fréquences de raies spectrales dudit signal de réponse distordu $Y_R(t)$ dans ladite première mesure.

4. Procédé pour déterminer la distorsion de phase $\varphi$ selon la revendication 3,
dans lequel lesdits signaux en phase et de phase en quadrature $Y_{IP}(t)$ et $Y_{QP}(t)$ comprennent chacun au total lesdites raies spectrales dudit signal de réponse distordu $Y_R(t)$ auxdites fréquences $f_i$ sélectionnées avec lesdites amplitudes $M_S$ mesurées dans ladite première mesure et dans lequel lesdites première, deuxième et troisième mesures pour déterminer ladite distorsion de phase $\varphi$ auxdites fréquences $f_i$ sélectionnées sont exécutées une fois.

5. Procédé pour déterminer la distorsion de phase $\varphi$ selon la revendication 3,
dans lequel ladite deuxième et ladite troisième mesures sont exécutées séparément pour chacune desdites fréquences $f_i$ sélectionnées, ce par quoi lesdits signaux en phase et de phase en quadrature $Y_{IP}(t)$ et $Y_{QP}(t)$ ne comprennent qu'une raie spectrale desdites raies spectrales sélectionnées dudit signal de réponse distordu $Y_R(t)$ avec ladite fréquence correspondante et ladite amplitude $M_S$ correspondante mesurée dans ladite première mesure.

6. Procédé pour déterminer la distorsion de phase $\varphi$ selon la revendication 4 ou 5,
dans lequel ladite distorsion de phase $\varphi$ auxdites fréquences $f_i$ sélectionnées est calculée par l'équation :

$$\varphi = \arctan((M_q^2 - M_s^2 - S_s^2) * S_c / ((M_i^2 - M_s^2 - S_c^2) * S_s))$$

dans laquelle

$M_S$ est ladite amplitude dudit signal de réponse distordu $Y_R(t)$ auxdites fréquences $f_i$ sélectionnées,
$M_i$ est ladite amplitude dudit signal $Y_i(t)$ généré par addition dudit signal de réponse distordu $Y_R(t)$ et dudit signal en phase $Y_{IP}(t)$ auxdites fréquences $f_i$ sélectionnées,
$M_q$ est ladite amplitude dudit signal $Y_q(t)$ généré par addition dudit signal de réponse distordu $Y_R(t)$ et dudit signal de phase en quadrature $Y_{QP}(t)$ auxdites fréquences $f_i$ sélectionnées,
$S_c$ est ladite amplitude dudit signal en phase $Y_{IP}(t)$ auxdites fréquences $f_i$ sélectionnées et
$S_s$ est ladite amplitude dudit signal de phase en quadrature $Y_{QP}(t)$ auxdites fréquences $f_i$ sélectionnées.

7. Appareil pour déterminer la distorsion de phase $\varphi$ causée par un dispositif en cours de test (6) comprenant un générateur de formes d'ondes (1, 3) pour générer un signal de test $Y_\tau(t)$, un signal en phase $Y_{IP}(t)$ et un signal de phase en quadrature $Y_{QP}(t)$ et un analyseur de spectre (13) pour mesurer successivement un signal de réponse distordu $Y_R(t)$ causé par un dispositif en cours de test (6) recevant ledit signal de test $Y_\tau(t)$, un signal $Y_i(t)$ généré par addition dudit signal de réponse distordu $Y_R(t)$ et dudit signal en phase $Y_{IP}(t)$ et un signal $Y_q(t)$ généré par addition dudit signal de réponse distordu $Y_R(t)$ et dudit signal de phase en quadrature $Y_{QP}(t)$,
dans lequel ledit signal en phase $Y_{IP}(t)$ et ledit signal de phase en quadrature $Y_{QP}(t)$ dépendent dudit signal de réponse distordu $Y_R(t)$,
dans lequel la phase dudit signal en phase $Y_{IP}(t)$ est phasée comme référence avec la phase dudit signal de test $Y_\tau(t)$,
dans lequel la phase dudit signal de phase en quadrature $Y_{QP}(t)$ est phasée en quadrature avec la phase dudit signal en phase $Y_{IP}(t)$ et

dans lequel ledit générateur de formes d'ondes (1, 3) comprend un premier générateur de formes d'ondes (1) générant ledit signal de test $Y_\tau(t)$ et un deuxième générateur de formes d'ondes (3) générant lesdits signaux en phase et de phase en quadrature $Y_{IP}(t)$, $Y_{QP}(t)$,
l'appareil comprenant en outre
un système de commande (3) pour synchroniser ladite phase desdits signaux en phase et de phase en quadrature $Y_{IP}(t)$, $Y_{QP}(t)$, dans ledit premier générateur de formes d'ondes (1) sur ladite phase dudit signal de test $Y_\tau(t)$ dans ledit deuxième générateur de formes d'ondes (3) et
une unité de calcul (14) pour calculer ladite distorsion de phase $\varphi$ causée par ledit dispositif en cours de test (6) sur la base d'une première amplitude $M_S$ mesurée dudit signal de réponse distordu $Y_R(t)$, d'une deuxième amplitude $M_i$ mesurée dudit signal $Y_i(t)$ et d'une troisième amplitude $M_q$ dudit signal $Yq(t)$.

8. Appareil pour déterminer la distorsion de phase $\varphi$ causée par un dispositif en cours de test selon la revendication 7, dans lequel ledit premier générateur de formes d'ondes (1, 3) est un générateur de formes d'ondes arbitraires générant des signaux de référence $Y_\tau(t)$ semblables à une modulation OFDM.

9. Appareil pour déterminer la distorsion de phase $\varphi$ causée par un dispositif en cours de test selon la revendication 7 ou 8,
dans lequel ledit dispositif en cours de test (6) a un comportement de transfert non linéaire conduisant à des raies spectrales d'ordre supérieur et à des raies spectrales d'intermodulation dans ledit signal de réponse distordu $Y_R(t)$.

10. Appareil pour déterminer la distorsion de phase $\varphi$ causée par un dispositif en cours de test selon l'une quelconque des revendications 7 à 9,
dans lequel ledit analyseur de spectre (13) est un analyseur de spectre de type scalaire.

Fig. 1

(state of the art)

Fig. 2

(state of the art)

Fig. 3

Start

S10 — generating the reference signal

S20 — measuring the spectral lines of the distorted response signal and selecting the frequencies for phase distortion

S30 — synchronising the phase of the inphase and the quadrature-phase signal with the phase of the test signal

S100

S40 — measuring the amplitudes of the spectral lines of the distorted response signal at the selected frequencies

S50 — adjusting the amplitudes of the spectral lines of the inphase and quadrature-phase signal

S60 — measuring the amplitudes of the spectral lines of the signal built by the distorted response and the inphase signal

S70 — measuring the amplitudes of the spectral lines of the signal built by the distorted response and the quadrature-phase signal

S200

S80 — calculating the two coordinates of the distorted response signal in the coordinate system for each selected frequency

S90 — determining the phase distortion for each selected frequency

End

Fig. 4

Fig. 5

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- DE 19857834 A1

- EP 0747714 A

### Non-patent literature cited in the description

- **CHRISTOPH RAUSCHER.** Grundlagen der Spektrumanalyse. Rohde & Schwarz GmbH & Co, 2000, 19-33